# EUROPÄISCHE PATENTSCHRIFT

(11) **EP 3 512 647 B1**
(45) Veröffentlichungstag und Bekanntmachung des Hinweises auf die Patenterteilung: **29.07.2020**
(21) Anmeldenummer: 17787300.7
(22) Anmeldetag: 12.09.2017
(51) Int. Cl.: B21D 5/00, B21D 5/02, H03K 17/00, G05B 19/18

(54) **BIEGEWERKZEUG, INSBESONDERE EIN OBERWERKZEUG ODER EINEN BIEGESTEMPEL, UND EIN BETRIEBSWECHSELVERFAHREN**
BENDING TOOL, IN PARTICULAR AN UPPER TOOL OR A BENDING PUNCH, AND A METHOD FOR CHANGING THE OPERATING MODE
OUTIL DE CINTRAGE, EN PARTICULIER OUTIL SUPÉRIEUR OU POINÇON DE CINTRAGE, ET PROCÉDÉ DE CHANGEMENT DE MODE

(30) Priorität: 16.09.2016 AT 508322016
(43) Veröffentlichungstag der Anmeldung: 24.07.2019
(73) Patentinhaber: TRUMPF Maschinen Austria GmbH & Co. KG., 4061 Pasching (AT)
(72) Erfinder: BINDER, Thomas, 4040 Linz (AT); CAHA, Philipp, 1210 Wien (AT); PITTRICH, Markus, 4072 Alkoven (AT)
(74) Vertreter: Burger, Hannes
(86) Internationale Anmeldenummer: PCT/AT2017/060226
(87) Internationale Veröffentlichungsnummer: WO 2018/049451

(56) Entgegenhaltungen:
- EP-A1- 1 520 641
- WO-A1-2016/094918
- AT-A1- 507 346
- AT-B1- 506 604
- US-A- 6 163 734

## Beschreibung

Die Erfindung betrifft ein Biegewerkzeug, insbesondere ein Oberwerkzeug oder einen Biegestempel.

Zum Freibiegen von Blechteilen an einer Biegemaschine, weist diese einen Druckbalken mit einer Werkzeugaufnahme auf, in welcher Werkzeugaufnahme Biegewerkzeuge eingelegt bzw. angeordnet werden können. Eine Biegemaschine weist zudem meist eine größere Längserstreckung auf, sodass längs dieser Erstreckung, mehrere Bearbeitungspositionen realisiert werden können, indem in der Werkzeugaufnahme an diskreten Positionen, mehrere unterschiedliche Typen von Biegewerkzeugen angeordnet werden können.

Bei der Durchführung der Biegeumformung wird von der Ablaufsteuerung dem Bediener vorgeschlagen bzw. vorgegeben, an welcher Position die nächste Biegeumformung durchzuführen ist. Daher ist es wichtig, dass die Maschinensteuerung bzw. Ablaufsteuerung prüfen kann, ob an der jeweiligen Position die korrekten Biegewerkzeuge eingelegt sind. Diesbezüglich ist beispielsweise aus der AT 506 604 B1 bekannt, dass im Befestigungsfortsatz des Biegewerkzeuges ein Identifikationskennzeichen angeordnet ist, welches im eingelegten Zustand von einer in der Werkzeugaufnahme angeordneten Gegenstelle kontaktlos ausgelesen wird. Insbesondere ist offenbart, dass über dieses Identifikationsmerkmal die Stellung einer Tastscheibe an eine Gegenstelle der Biegemaschine übermittelt wird. Diese Tastscheibe berührt während des Biegevorgang das sich aufbiegende Blech, wodurch eine Bestimmung des aktuellen Biegewinkels bereits während der Biegeumformung möglich wird. Dieses System ist dabei derart ausgelegt, dass die für das Auslesen erforderliche elektrische Energie, vom auslesenden Signal, insbesondere einem elektromagnetischen Wechselsignal, bereitgestellt wird.

Nachteilig an dieser Ausführung ist jedoch, dass aufgrund der gegebenen Platzverhältnisse und der geringen zur Verfügung stehenden elektrischen Energie, das Maß der Aufbiegung nur mit einer reduzierten Genauigkeit erfasst werden kann.

Es ist aus dem Stand der Technik bekannt, beispielsweise RFID Merkmale oder auch kontaktlose Chipkarten mit ausreichend elektrischer Energie zu versorgen, um auch komplexe Abläufe und Funktionalität mit elektrischer Energie zu versorgen. Aufgrund der weiten Verbreitung von Biegewerkzeugen mit einem quasi-passivem Auslesen des Identifikationsmerkmals, ist eine Änderung der drahtlosen Schnittstelle nicht möglich, da dies zu Inkompatibilitäten mit bestehenden Biegemaschinen führen würde. Denn dann müssten die Gegenstellen in allen Werkzeugaufnahmen ausgetauscht werden bzw. besteht eine Beschädigungsgefahr für bestehende Biegewerkzeuge.

Es ist also Aufgabe der Erfindung ein Biegewerkzeug dahingehend zu verbessern, dass dieses mit existierenden Biegemaschinen kompatibel ist und insbesondere eine Werkzeugerkennung durch Auslesen eines Identifikationsmerkmals ermöglicht. Das Biegewerkzeug soll jedoch dahingehend ausgebildet sein, zusätzliche sowie erweiterte Funktionalität zu bieten.

Diese Aufgabe wird durch ein Biegewerkzeug gelöst, insbesondere ein Oberwerkzeug oder einen Biegestempel. Das Biegewerkzeug umfasst einen Werkzeugkörper mit einem oberen und einem gegenüberliegenden unteren Endbereich, wobei im oberen Endbereich ein Befestigungsfortsatz und im unteren Endbereich eine Arbeitsspitze ausgebildet ist. Der Befestigungsfortsatz ist zur Aufnahme des Biegewerkzeugs in einer Werkzeugaufnahme ausgebildet, und weist dazu einen Klemmabschnitt auf. Ferner ist im Werkzeugkörper ein Werkzeug-Identifikationskennzeichen angeordnet. Im Befestigungsfortsatz, insbesondere außerhalb des Klemmabschnitts, ist an zumindest einer Seitenfläche und diese nicht überragend, eine Kommunikationsschnittstelle angeordnet, welche über eine Verbindungsleitung mit dem Werkzeug-Identifikationskennzeichen verbunden ist. Im Werkzeugkörper ist zusätzlich eine Elektronikeinheit angeordnet. Am Befestigungsfortsatz ist ein gegenüber dem Werkzeugkörper elektrisch isolierter Spannungsversorgungskontakt angeordnet, welcher mit einem Spannungsversorgungsmodul der Elektronikeinheit verbunden ist. In der Verbindungsleitung ist ein Umschalter mit zwei Eingängen und einem Ausgang angeordnet ist, wobei der Ausgang mit der Kommunikationsschnittstelle und einer der Eingänge mit dem Werkzeug-Identifikationskennzeichen und der andere Eingang mit der mit der Elektronikeinheit verbunden ist. In einer ersten Schaltstellung, insbesondere einer Ruhestellung des Umschalters, ist das Werkzeug-Identifikationskennzeichen über den Umschalter mit der Kommunikationsschnittstelle verbunden, und in zweiten Schaltstellung des Umschalters, ist die Elektronikeinheit über den Umschalter mit der Kommunikationsschnittstelle verbunden. Die erste Schaltstellung legt eine passive Betriebsart des Biegewerkzeugs und die zweite Schaltstellung eine aktive Betriebsart des Biegewerkzeugs fest.

Das gegenständliche Biegewerkzeug wird bevorzugt in einer Biegepresse eingesetzt werden, wo es in der bzw. von der Werkzeugaufnahme gehalten wird. Die Bezeichnungen oberer und unterer Endbereich sind somit in Bezug auf die vertikal ausgerichtete Einbaulage zu verstehen. Daher ist die Arbeitsspitze als jener unterste Teil des Biegewerkzeugs zu verstehen, der ein umzuformendes Werkstück kontaktiert und durch Einbringen der Biegekraft, das Werkstück umformt.

Mit dieser Ausbildung ist in vorteilhafter Weise gewährleistet, dass eine automatische Wahl der Betriebsart des Biegewerkzeugs erreicht wird. Insbesondere ist es möglich, das gegenständliche fortschrittliche Biegewerkzeug auch in Werkzeugaufnahmen verwenden zu können, welche eine aktive Betriebsart nicht unterstützen. In Abhängigkeit von der Ausbildung der Werkzeugaufnahme ist daher ein rein aktiver, ein rein passiver, oder ein wahlfrei gemischter Einsatz möglich.

Nach einer Weiterbildung ist vorgesehen, dass der Umschalter als elektronischer Schalter ausgebildet ist, insbesondere als Halbleiterschalter. Elektronische Schalter haben den Vorteil, dass ein sehr schnelles umschalten und vor allem bei Kleinspannungen auch eine sichere Kontaktgabe gewährleistet ist. In einer bevorzugten Ausführung erfolgt beträgt die Versorgungsspannung 16V, welche über eine Beschaltung auf 5V gesenkt wird. Gerade bei kleinen Schaltspannungen und geringen zu schaltenden Strömen haben mechanische Schalter den Nachteil, dass sich auf den Schaltkontakten dünne isolierende Schichten bilden können, die eine zuverlässige Kontaktgabe behindern. Hier haben Halbleiterschalter den besonderen Vorteil, dass ein nicht-mechanischer Halbleiterkanal bspw. eines FETs, leitend geschaltet wird.

Im Hinblick auf eine sichere und ungestörte Signalübertragung von der Elektronikeinheit zur Kommunikationsschnittstelle ist es von Vorteil, wenn der Umschalter kapazitätsarm ausgebildet ist. Die zwischen der Elektronikeinheit und der Kommunikationsschnittstelle zu übertragenden Signale sind zumeist Digitalsignale geringer Amplitude, bei denen eine möglichst verzerrungsfreie bzw. verzerrungsarme Übertragung des Signals erforderlich ist, um das Signal über die Kommunikationsschnittstelle übertragen und nachgelagert auswerten zu können. Kapazitäten im Signalweg, insbesondere im Umschalter, beeinträchtigen die zuverlässige Signalübertragung und können sogar einen Verlust der Kommunikation verursachen. Neben der Verbindungsleitung hat der Umschalter einen bedeutenden Anteil an der gesamten kapazitiven Beeinflussung des Signalwegs, sodass ein kapazitätsarmer Umschalter von Vorteil ist. Beispielsweise wird als Übertragungs- bzw. Modulationsverfahren eine PAM verwendet, wobei dem Fachmann weitere Übertragungsverfahren bekannt sind.

Von Vorteil ist ferner eine Weiterbildung, nach der ein Steueranschluss des Umschalters mit einem Überwachungsmodul des Spannungsversorgungsmoduls verbunden ist, welches Überwachungsmodul dazu ausgebildet ist, den Umschalter zwischen den beiden Schaltstellungen umzusteuern. Nur wenn das Biegewerkzeug in einer Werkzeugaufnahme angeordnet ist, welche am Spannungsversorgungskontakt eine elektrische Spannung bereitstellen kann, wird automatisch die passive Betriebsart beendet und auf die aktive Betriebsart gewechselt. Beziehungsweise wird bei Beendigung der Spannungsversorgung, bspw. bei der Entnahme des Biegewerkzeugs aus der Werkzeugaufnahme, wieder automatisch auf die passive Betriebsart zurück gewechselt.

Da manche Biegewerkzeuge bezüglich ihrer Vertikalerstreckung symmetrisch ausgebildet sind, ist nach einer Weiterbildung vorgesehen, dass die Kommunikationsschnittstelle auf zwei gegenüberliegenden Seitflächen des Befestigungsfortsatzes angeordnet ist. Somit muss beim Einlegen des Biegewerkzeugs in die Werkzeugaufnahme nicht auf die korrekte Ausrichtung Acht gegeben werden.

Es kann auch vorgesehen sein, dass die aktive Betriebsart des gegenständlichen Biegewerkzeugs nur in speziellen Werkzeugaufnahmen aktivierbar sein soll. Daher kann vorgesehen sein, dass im Klemmabschnitt ein Betätigungselement angeordnet ist, welches mit dem Spannungsversorgungskontakt bewegungsverbunden ist, und zur Bewegung dieses Spannungsversorgungskontakts zwischen einer, die Seitfläche nicht überragenden, und einer, die Seitfläche überragende Position ausgebildet ist. Mit der gegenständlichen Weiterbildung ist durch mechanisch-konstruktive Eigenschaften des Biegewerkzeugs sichergestellt, dass der Spannungsversorgungskontakt nur dann ausgefahren wird, wenn sich das Werkzeug in einer Werkzeugaufnahme befindet. Somit ist der Spannungsversorgungskontakt bei Manipulationshandlungen des Werkzeugs, bspw. beim Einlagern in einem Werkzeugspeicher oder Einlegen bzw. Entnahme aus der Werkzeugaufnahme, zuverlässig vor Beschädigung geschützt.

Eine Weiterbildung besteht auch darin, dass die Elektronikeinheit in einer Ausnehmung des Werkzeugkörpers angeordnet ist. Somit sind die Elektronikkomponenten während des bestimmungsgemäßen Einsatzes des Biegewerkzeugs geschützt. Zusätzlich ist gewährleistet, dass für die Auswerteelektronik kein zusätzlicher Platzbedarf erforderlich ist, wodurch es zu einer Einschränkung des verfügbaren Arbeitsraums kommen würde.

Nach einer Weiterbildung ist ferner vorgesehen, dass die Elektronikeinheit mit einem Biege-Kenndatensensor verbunden ist, und welcher Biege-Kenndatensensor bevorzugt im unteren Endbereich angeordnet ist. Mit dieser Ausführung wird erreicht, dass in möglichst unmittelbarer Nähe der Biegelinie der sich einstellende Biegewinkel ermittelt werden kann. Entlang der Biegelinie wird das umzuformende Blech vom Biegewerkzeug kontaktiert und aufgrund der Krafteinleitung umgeformt. Durch eine möglichst nahe der Biegelinie erfolgende Erfassung des sich einstellenden Biegewinkels kann sehr gut und vor allem sehr früh korrigierend eingegriffen werden, um den geforderten Biegewinkel ausbilden zu können.

Eine Weiterbildung besteht darin, dass der Biege-Kenndatensensor als Tastscheibensensor ausgebildet ist. Somit ist eine Erfassung des sich einstellenden Biegewinkels während der Durchführung der Biegung und vor allem möglichst nahe an der Biegelinie möglich.

Nach einer Weiterbildung ist vorgesehen, dass im Werkzeug-Identifikationskennzeichen ein Überbrückungsschalter angeordnet ist, welcher insbesondere im aktiven Betriebszustand geschlossen ist. Das Werkzeug-Identifikationskennzeichen ist für einen passiven Betrieb ausgelegt, und wird somit zumeist mit sehr geringen Signalpegeln arbeiten, bzw. werden sich die elektrischen Parameter der Leitungscharakteristik (bspw. Kapazitätsbelag, Wellenwiderstand, ..) von jenen des aktiven Betriebs unterscheiden. Mit dieser Weiterbildung lässt sich nun gewährleisten, dass es im aktiven Betrieb zu keinen gegenseitigen Störungen des Werkzeug-Identifikationskennzeichens und der Elektronikeinheit kommt. Dieser Überbrückungsschalter kann bspw. als Kurzschlussschalter ausgebildet sein, um die Signalleitung zwischen dem Werkzeug-Identifikationskennzeichen und dem Umschalter, welche zweipolig ausgeführt sein wird, kurzzuschliessen. Dadurch kann es auch zu keiner Rückwirkung des im Werkzeug-Identifikationskennzeichens auf den Umschalter kommen.

Eine Weiterbildung besteht auch darin, dass die Kommunikationsschnittstelle drahtlos und zur Übertragung von elektrischer Energie und Kommunikationsdaten ausgebildet ist. Damit wird in vorteilhafter Weise erreicht, dass durch das Anordnen des Biegewerkzeugs in der Werkzeugaufnahme, die datentechnische Kommunikation und die Versorgung mit elektrischer Energie gewährleistet ist, ohne dass dafür eine eigenständige Verbindung hergestellt werden müsste.

Um eine möglichst geringe Beeinflussung des Arbeitsablaufs zu gewährleisten ist es von Vorteil, wenn gemäß einer Weiterbildung, die Kommunikationsschnittstelle drahtlos ausgebildet ist. Somit besteht für den Maschinenbediener beim Rüsten der Maschine kein Unterschied zwischen einem Standard-Biegewerkzeug und dem gegenständlichen, weiterentwickelten Biegewerkzeug.

Im Umfeld von Werkzeugmaschinen kann es durch die Vielzahl der zumeist über Frequenzumrichter angetriebenen Motoren, bzw. auch durch die massiven Metallteile zu Störungen einer drahtlosen Kommunikation kommen. Daher kann gemäß einer Weiterbildung vorgesehen sein, dass die Kommunikationsschnittstelle als kontaktbasierter Mehrfachkontakt ausgebildet ist.

Die Aufgabe der Erfindung wird auch durch ein Betriebswechselverfahren eines gegenständlichen Biegewerkzeugs gelöst. Das Biegewerkzeug ist mit dem Befestigungsfortsatz in einer Werkzeugaufnahme derart eingelegt, dass die Kommunikationsschnittstelle am Befestigungsfortsatz einer Kommunikationsgegenstelle der Werkzeugaufnahme gegenüberliegend angeordnet ist. Ferner ist somit das Werkzeug-Identifikationsmerkmal mit der Kommunikationsschnittstelle verbunden, was dem passiven Betriebszustand des Biegewerkzeugs entspricht. Vom Überwachungsmodul des Spannungsversorgungsmoduls wird der Spannungsversorgungskontakt überwacht und bei Erkennen einer elektrischen Spannung am Spannungsversorgungskontakt ein Umschaltsignal generiert, welches aufgrund der Verbindung des Überwachungsmoduls mit dem Umschalter, auch an diesem anliegt. Dann wird durch den Umschalter die Verbindung zwischen dem Werkzeug-Identifikationskennzeichen und der Kommunikationsschnittstelle getrennt und eine Verbindung zwischen der Elektronikeinheit und der Kommunikationsschnittstelle hergestellt. Dies geschieht durch Anwenden des Umschaltsignals und damit Umsteuern des Umschalters in die zweite Schaltstellung, was dem aktiven Betriebszustand des Biegewerkzeugs entspricht. Diese Verbindung zwischen der Elektronikeinheit und der Kommunikationsschnittstelle wird bis zur Erkennung einer fehlenden elektrischen Spannung am Spannungsversorgungskontakt aufrechterhalten. Dann erfolgt ein Beenden des aktiven Betriebszustands und Herstellen des passiven Betriebszustands durch den Umschalter.

Unter Anwenden des Signals wird hierin verstanden, dass am Umschalter der Umschaltvorgang durchgeführt wird. Bei einem elektromechanischen Umschalter wird bspw. die Erregerspule mit Energie versorgt, wodurch der Umschaltkontakt bewegt wird. Bei einem elektronischen Schalter wird zumeist eine Spannung an den Schalter gelegt, wodurch bspw. ein ohne Anregung selbstsperrender Kanal leitend wird.

Nach einer Weiterbildung ist auch vorgesehen, dass vor Herstellung des aktiven Betriebszustands, durch Anwenden des Umschaltsignals, der Überbrückungsschalter geschlossen wird. Diese Weiterbildung hat den Vorteil, dass dadurch eine sichere Trennung der Komponenten des passiven und des aktiven Betriebszustands erreicht wird.

Zum besseren Verständnis der Erfindung wird diese anhand der nachfolgenden Figuren näher erläutert.

Es zeigen jeweils in stark vereinfachter, schematischer Darstellung:
- Fig. 1: eine Prinzipdarstellung des gegenständlichen Biegewerkzeugs;
- Fig. 2: ein elektrisches Ersatzschaltbild des passiven Betriebs des Biegewerkzeugs;
- Fig. 3: ein elektrisches Ersatzschaltbild des aktiven Betriebs des Biegewerkzeugs, mit einer weiteren Option eines Überbrückungsschalters.

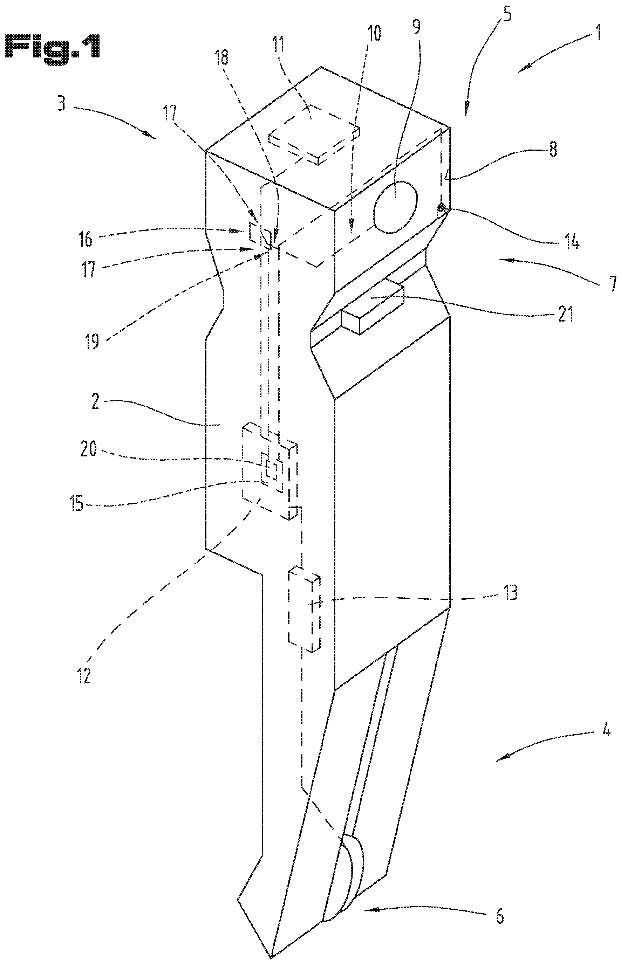

Fig. 1 zeigt das gegenständliche Biegewerkzeug 1, insbesondere ein Oberwerkzeug oder einen Biegestempel, welches Biegewerkzeug 1 einen Werkzeugkörper 2 mit einem oberen Endbereich 3 und einem gegenüberliegenden unteren Endbereich 4 aufweist. Im oberen Endbereich 3 ist ein Befestigungsfortsatz 5, im unteren Endbereich 4 ist eine Arbeitsspitze 6 ausgebildet. Der Befestigungsfortsatz 5 ist zur Aufnahme des Biegewerkzeuges 1 in einer nicht dargestellten Werkzeugaufnahme ausgebildet und weist dazu einen Klemmabschnitt 7 auf.

Am Befestigungsfortsatz 5, insbesondere jedoch außerhalb des Klemmabschnitts 7, ist an zumindest einer Seitenfläche 8 und diese nicht überragend, eine Kommunikationsschnittstelle 9 angeordnet. Diese Kommunikationsschnittstelle 9 ist über eine Verbindungsleitung 10 mit einem Werkzeug-Identifikationskennzeichen 11 verbunden, welches Werkzeug-Identifikationskennzeichen 11 im Werkzeugkörper 2 angeordnet ist, insbesondere in einer Ausnehmung im oberen Endbereich 3. Im Werkzeugkörper 2 ist insbesondere auch in einer Ausnehmung desselben, eine Elektronikeinheit 12 angeordnet, welche mit einem Biege-Kenndatensensor 13 verbunden ist. Merkmale dieses Biege-Kenndatensensors 13 werden nicht weiter ausgeführt, da sie für die gegenständliche Ausführung des Biegewerkzeugs nicht von Bedeutung sind.

Am Befestigungsfortsatz 5 ist ferner an zumindest einer Seitenfläche 8 ein gegenüber dem Werkzeugkörper 2 elektrisch isolierter Spannungsversorgungskontakt 14 angeordnet, welcher Spannungsversorgungskontakt 14 mit einem Spannungsversorgungsmodul 15 der Elektronikeinheit 12 verbunden ist.

In der Verbindungsleitung 10 zwischen der Kommunikationsschnittstelle 9 und dem Werkzeug-Identifikationskennzeichen 11 ist ein Umschalter 16 angeordnet, welcher Umschalter zwei Eingänge 17 und einen Ausgang 18 aufweist. Der Ausgang 18 ist mit der Kommunikationsschnittstelle 9 verbunden, einer der Eingänge 17 ist mit dem Werkzeug-Identifikationskennzeichen 11 der andere Eingang 17 ist mit der Elektronikeinheit 12 verbunden. In einer ersten Schaltstellung, welche einer Ruhestellung des Umschalters 16 entspricht, ist das Werkzeug-Identifikationskennzeichen 11 über den Umschalter 16 mit der Kommunikationsschnittstelle 9 verbunden. In dieser Schaltstellung ist eine passive Betriebsart des Biegewerkzeuges 1 festgelegt. In einer zweiten Schaltstellung des Umschalters 16, ist die Elektronikeinheit 12 über den Umschalter 16 mit der Kommunikationsschnittstelle 9 verbunden, wodurch eine aktive Betriebsart des Biegewerkzeugs festgelegt ist.

Zum Wechsel der Schaltstellungen des Umschalters 16 ist dieser über einen Steueranschluss 19 mit einem Überwachungsmodul 20 des Spannungsversorgungsmoduls 15 verbunden.

Bei Anordnung des Biegewerkzeugs 1 in einer Werkzeugaufnahme, wird das im Klemmabschnitt 7 angeordnete und mit dem Spannungsversorgungskontakt 14 bewegungsverbundene Betätigungselement 21 von der Werkzeugaufnahme eingedrückt, sodass der Spannungsversorgungskontakt 14 ausgefahren wird und die Seitenfläche 8 des Befestigungsfortsatzes 5 überragt. Bei einer gewöhnlichen Werkzeugaufnahme wird der Spannungsversorgungskontakt 14 daher zumeist die Werkzeugaufnahme kontaktieren. Da diese keine Spannungsversorgungsschiene aufweist, wird das Biegewerkzeug 1 im passiven Betriebszustand bleiben. Bei Anordnung des Biegewerkzeugs 1 in einer fortschrittlichen Werkzeugaufnahme, wird der Spannungsversorgungskontakt 14 eine Spannungsversorgungsschiene der Werkzeugaufnahme kontaktieren. Liegt an dieser Spannungsversorgungsschiene elektrische Spannung an, wird der Umschalter 16 aktiviert, und das Biegewerkzeug 1 befindet sich im aktiven Betriebsmodus. Liegt keine elektrische Spannung an, bleibt das Biegewerkzeug auch in einer fortschrittlichen Werkzeugaufnahme im passiven Betriebsmodus. Somit kann über das Anlegen einer elektrischen Spannung an die Spannungsversorgungsschiene wahlfrei zwischen aktiven und passiven Betriebsmodus des Biegewerkzeugs 1 gewechselt werden.

Gemäß einer weiteren möglichen Ausführung kann vorgesehen sein, dass die Kommunikationsschnittstelle 9 und der Spannungsversorgungskontakt 14 auch an der gegenüberliegenden Seitenfläche angeordnet ist, sodass beim Anordnen des Biegewerkzeuges 1 in der Werkzeugaufnahme auf eine Ausrichtung des Biegewerkzeuges 1 nicht Achtgegeben werden muss. Bevorzug ist dann auch das Betätigungselement 21 im gegenüberliegenden Klemmabschnitt 7 angeordnet, sodass das Herausbewegen des Spannungsversorgungskontakts 14 in jeder Anordnungsausrichtung des Biegewerkzeuges gewährleistet ist.

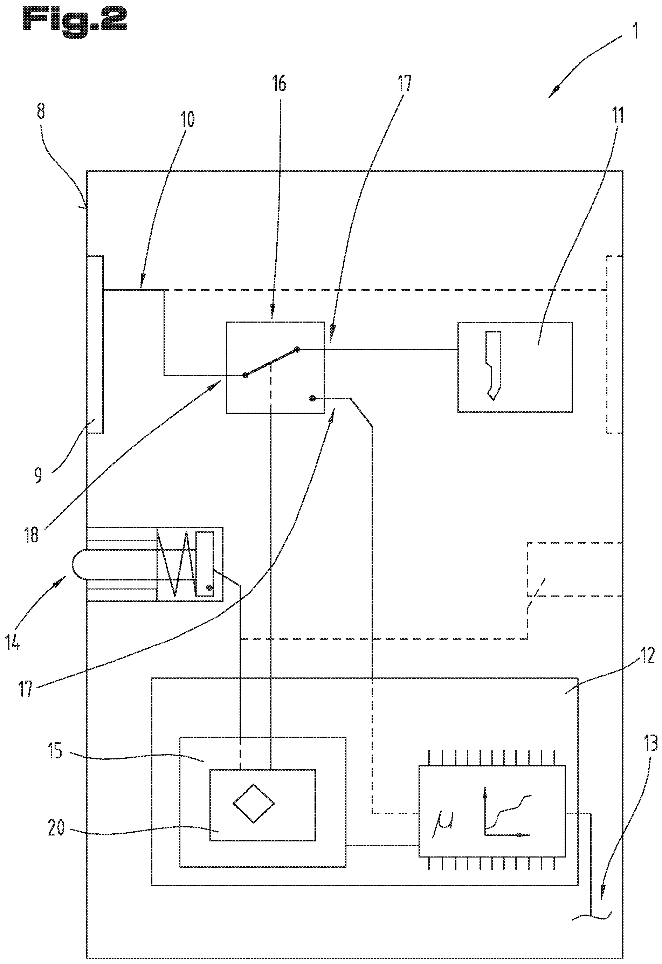

Fig. 2 zeigt eine Prinzipdarstellung der elektrischen bzw. elektronischen Komponenten zur Umschaltung des gegenständlichen Biegewerkzeuges 1 zwischen dem passiven und aktiven Betriebszustand. In der Figur ist der passive Betriebszustand dargestellt, bei dem das gegenständliche Biegewerkzeug 1 in einer nicht fortschrittlichen Werkzeugaufnahme einer weit verbreiteten Biegemaschine angeordnet ist. An einer Seitenfläche 8 ist, dieses nicht überragend, eine Kommunikationsschnittstelle 9 angeordnet, wobei diese Kommunikationsschnittstelle 9 bevorzugt zur drahtlosen Kommunikation mit einer entsprechenden Gegenstelle der Werkzeugaufnahme ausgebildet ist. Ebenfalls in der Seitenfläche 8 ist ein Spannungsversorgungskontakt 14 angeordnet, welcher durch die Klemmung des Werkzeugs und das damit verbundene Eindrücken des Betätigungselements, ausgefahren ist, und somit die Seitenfläche 8 überragt. Aus Vereinfachungsgründen und da es für das gegenständliche Biegewerkzeug nicht von Bedeutung ist, wurde der Klemmabschnitt, das Betätigungselement und der Mechanismus zur Positionsänderung des Spannungsversorgungskontakts 14, in der Figur nicht dargestellt. Gemäß vorteilhafter Weiterbildungen können auch an der gegenüberliegenden Seitenfläche eine Kommunikationsschnittstelle und ein Spannungsversorgungskontakt angeordnet sein. In der Figur ist dies durch eine strichlierte Darstellung der Komponenten und der Verbindungsleitungen angedeutet. Im Weiteren wird von einer Kommunikationsschnittstelle und einem Spannungsversorgungskontakt gesprochen, wobei jedoch auch die doppelseitige Ausführung mitumfasst ist.

Der Spannungsversorgungskontakt 14 ist federnd gehalten, sodass das Biegewerkzeug 1 auch in einer Werkzeugaufnahme angeordnet werden kann, bei welcher kein, oder ein zu geringer Platz für einen solchen Kontakt vorgesehen ist. Der Kontakt wird dann nicht, oder nur teilweise ausfahren, jedenfalls kommt es durch diese Ausführung zu keiner Beschädigung des Spannungsversorgungskontakts 14.

Im passiven Betriebszustand des Biegewerkzeuges 1 befindet sich der Umschalter 16 in seiner ersten Schaltstellung bzw. in Ruhestellung. Dabei ist ein Eingang 17 der beiden Eingänge, mit dem Werkzeug-Identifikationskennzeichen 11 verbunden, der Ausgang 18 des Umschalters 16 ist über die Verbindungsleitung 10 mit der Kommunikationsschnittstelle 9 verbunden. Aufgrund der fehlenden Spannungsversorgung ist die Elektronikeinheit 12 deaktiviert, sodass am zweiten Eingang 17 des Umschalters 16 kein Signal anliegt. Aufgrund der fehlenden Versorgungsspannung wird selbstverständlich vom Überwachungsmodul 20 des Spannungsversorgungsmoduls 15 auch kein Umschaltsignal erzeugt.

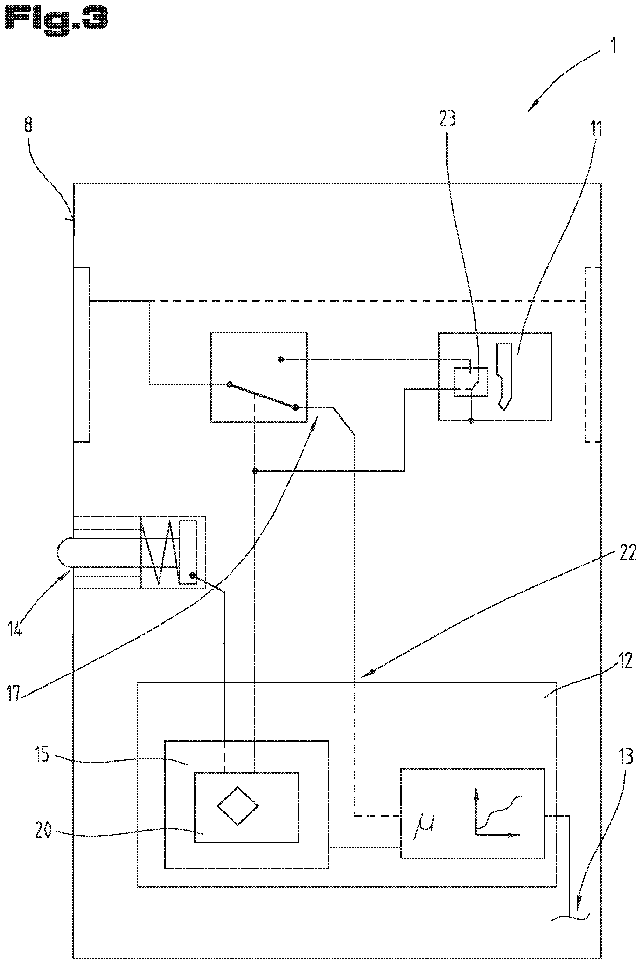

Fig. 3 zeigt die Situation im aktiven Betriebszustand, bei dem das gegenständliche Biegewerkzeug 1 in einer fortschrittlichen Werkzeugaufnahme angeordnet ist. Durch die Werkzeugklemmung wird das Betätigungselement im Klemmabschnitt eingedrückt, wodurch der Spannungsversorgungskontakt 14 über die Seitenfläche 8 hervorragt.

Im angeordneten Zustand kontaktiert der Spannungsversorgungskontakt 14 eine dem Kontakt gegenüberliegende Kontaktfläche in der Werkzeugaufnahme, sodass über die Verbindungsleitung zwischen dem Spannungsversorgungsmodul 15 und der Elektronikeinheit 12, diese mit elektrischer Energie versorgt wird. Vom Überwachungsmodul 20 des Spannungsversorgungsmoduls 15 wird das Anliegen einer elektrischen Spannung am Spannungsversorgungskontakt 14 überwacht. Sobald eine anliegende elektrische Spannung erkannt wird, wird vom Überwachungsmodul 20 ein Umschaltsignal generiert, welches über die Verbindungsleitung zwischen dem Überwachungsmodul 20 und dem Umschalter 16, an diesem anliegt bzw. an diesen übermittelt wird. Durch Anliegen dieses Umschaltsignals wird der Umschalter 16 in seine zweite Schaltstellung umgesteuert, und verbindet dann die Elektronikeinheit 12, insbesondere einen Datenausgang 22 der Elektronikeinheit 12, über den zweiten Eingang 17 des Umschalter 16 mit der Kommunikationsschnittstelle 9. Von der Elektronikeinheit 12 wird hernach der Biege-Kenndatensensor 13 ausgewertet, die erfassten Kenndaten aufbereitet und über die Kommunikationsschnittstelle 9 an die Maschinensteuerung bzw. eine Ablaufsteuerung übermittelt.

Wird vom Überwachungsmodul 20 erkannt, dass am Spannungsversorgungskontakt 14 keine elektrische Spannung mehr anliegt, wird der aktive Betriebszustand beendet und zum passiven Betriebszustand zurückgekehrt, beispielsweise indem ein weiteres Umschaltsignal generiert wird bzw. das aufrechte Umschaltsignal vom Umschalter 16 entfernt bzw. abgeschaltet wird. Dieser wird somit in seine erste Schaltstellung bzw. Ruhestellung zurückkehren und wiederum das Werkzeug-Identifikationskennzeichen 11 mit der Kommunikationsschnittstelle 9 verbinden.

Da der Umschalter 16 bevorzugt als elektronischer Schalter ausgebildet ist, beispielsweise als FET-Schalter, und somit eine Trennung der beiden Eingänge 17 nur über Halbleiter-Sperrschichten bzw. gesperrte Kanäle erfolgt, können sich kapazitive Kopplungen ausbilden, die eine zuverlässige Trennung der beiden Eingänge gegeneinander beeinträchtigen können. Insbesondere kann es durch das Werkzeug-Identifikationskennzeichen 11 im aktiven Betriebszustand gegebenenfalls zu einer Störung der Kommunikation zwischen der Elektronikeinheit 12 und der Gegenstelle kommen. Daher kann optional, gemäß einer weiteren Ausbildung vorgesehen sein, dass im Werkzeug-Identifikationskennzeichen 11 ein Überbrückungsschalter 23 angeordnet ist, an welchem auch das Umschaltsignal anliegt, sodass dieser im aktiven Betriebszustand geschlossen ist. Dadurch lässt sich eine Rückwirkung des Werkzeug-Identifikationskennzeichens auf den Umschalter und über eine kapazitive Beeinflussung auch auf die Kommunikation zwischen der Elektronikeinheit und der Gegenstelle verhindern.

Der besondere Vorteil des gegenständlichen Biegewerkzeuges liegt darin, dass dieses in Werkzeugaufnahmen von aktuell verwendeten und weit verbreiteten Biegemaschinen verwendet werden kann und dort eine passive Identifikation des Biegewerkzeuges ermöglicht. Zusätzlich ist es im aktiven Betriebszustand möglich, Messdaten eines Biegekenndatensensors auszuwerten und über dieselbe Kommunikationsschnittstelle an eine Gegenstelle zu übermitteln. Diese Umschaltung geschieht dabei automatisch, ohne dass vom Maschinenbediener diesbezüglich eine Handlung gesetzt werden müsste.

Abschließend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

- 1: Biegewerkzeug
- 2: Werkzeugkörper
- 3: oberer Endbereich
- 4: unteren Endbereich
- 5: Befestigungsfortsatz
- 6: Arbeitsspitze
- 7: Klemmabschnitt
- 8: Seitenfläche
- 9: Kommunikationsschnittstelle
- 10: Verbindungsleitung
- 11: Werkzeug-Identifikationskennzeichen
- 12: Elektronikeinheit
- 13: Biege-Kenndatensensor
- 14: Spannungsversorgungskontakt
- 15: Spannungsversorgungsmodul
- 16: Umschalter
- 17: Eingang
- 18: Ausgang
- 19: Steueranschluss
- 20: Überwachungsmodul
- 21: Betätigungselement
- 22: Datenausgang
- 23: Überbrückungsschalter

## Patentansprüche

1. Biegewerkzeug (1), insbesondere Oberwerkzeug oder Biegestempel, umfassend einen Werkzeugkörper (2) mit einem oberen (3) und einem gegenüberliegenden unteren Endbereich (4), wobei im oberen Endbereich (3) ein Befestigungsfortsatz (5) und im unteren Endbereich (4) eine Arbeitsspitze (6) ausgebildet ist,
wobei der Befestigungsfortsatz (5) zur Aufnahme des Biegewerkzeugs (1) in einer Werkzeugaufnahme ausgebildet ist, und einen Klemmabschnitt (7) aufweist, und
wobei im Werkzeugkörper (2) ein Werkzeug-Identifikationskennzeichen (11) angeordnet ist, und
wobei im Befestigungsfortsatz (5), insbesondere außerhalb des Klemmabschnitts (7), an zumindest einer Seitenfläche (8) und diese nicht überragend, eine Kommunikationsschnittstelle (9) angeordnet ist, welche über eine Verbindungsleitung (10) mit dem Werkzeug-Identifikationskennzeichen (11) verbunden ist,
**dadurch gekennzeichnet, dass**
• im Werkzeugkörper (2) eine Sensor-Auswerteelektronik (12) angeordnet ist, und
• dass am Befestigungsfortsatz (5) ein gegenüber dem Werkzeugkörper (2) elektrisch isolierter Spannungsversorgungskontakt (14) angeordnet ist, welcher mit einem Spannungsversorgungsmodul (15) der Elektronikeinheit (12) verbunden ist, und
• dass in der Verbindungsleitung (10) ein Umschalter (16) mit zwei Eingängen (17) und einem Ausgang (18) angeordnet ist, wobei der Ausgang (18) mit der Kommunikationsschnittstelle (9) und einer der Eingänge (17) mit dem Werkzeug-Identifikationskennzeichen (11) und der andere Eingang (17) mit der mit der Elektronikeinheit (12) verbunden ist und
• dass in einer ersten Schaltstellung, insbesondere einer Ruhestellung des Umschalters (16), das Werkzeug-Identifikationskennzeichen (11) über den Umschalter (16) mit der Kommunikationsschnittstelle (9) verbunden ist, und
dass in zweiten Schaltstellung des Umschalters (16), die Elektronikeinheit (12) über den Umschalter (16) mit der Kommunikationsschnittstelle (9) verbunden ist,
wobei die erste Schaltstellung eine passive Betriebsart des Biegewerkzeugs (1) und die zweite Schaltstellung eine aktive Betriebsart des Biegewerkzeugs (1) festlegt.

2. Biegewerkzeug nach Anspruch 1, **dadurch gekennzeichnet, dass** der Umschalter (16) als elektronischer Schalter ausgebildet ist, insbesondere als Halbleiterschalter.

3. Biegewerkzeug nach Anspruch 1 oder 2, **dadurch gekennzeichnet, dass** der Umschalter (16) kapazitätsarm ausgebildet ist.

4. Biegewerkzeug nach einem der Ansprüche 1 bis 3, **dadurch gekennzeichnet, dass** ein Steueranschluss (19) des Umschalters (16) mit einem Überwachungsmodul (20) des Spannungsversorgungsmoduls (15) verbunden ist, welches Überwachungsmodul (20) dazu ausgebildet ist, den Umschalter (16) zwischen den beiden Schaltstellungen umzusteuern.

5. Biegewerkzeug nach einem der Ansprüche 1 bis 4, **dadurch gekennzeichnet, dass** die Kommunikationsschnittstelle (9) auf zwei gegenüberliegenden Seitflächen des Befestigungsfortsatzes (5) angeordnet ist.

6. Biegewerkzeug nach einem der Ansprüche 1 bis 5, **dadurch gekennzeichnet, dass** im Klemmabschnitt (7) ein Betätigungselement (21) angeordnet ist, welches mit dem Spannungsversorgungskontakt (14) bewegungsverbunden ist, und zur Bewegung dieses Spannungsversorgungskontakts (14) zwischen einer, die Seitenfläche (8) nicht überragenden, und einer, die Seitenfläche (8) überragende Position ausgebildet ist.

7. Biegewerkzeug nach einem der Ansprüche 1 bis 6, **dadurch gekennzeichnet, dass** die Elektronikeinheit (12) in einer Ausnehmung des Werkzeugkörpers (2) angeordnet ist.

8. Biegewerkzeug nach einem der Ansprüche 1 bis 7, **dadurch gekennzeichnet, dass** welche Elektronikeinheit (12) mit einem Biege-Kenndatensensor (13) verbunden ist, und welcher Biege-Kenndatensensor (13) bevorzugt im unteren Endbereich (4) angeordnet ist.

9. Biegewerkzeug nach Anspruch 8, **dadurch gekennzeichnet, dass** der Biege-Kenndatensensor (13) als Tastscheibensensor ausgebildet ist.

10. Biegewerkzeug nach einem der Ansprüche 1 bis 9, **dadurch gekennzeichnet, dass** im Werkzeug-Identifikationskennzeichen (11) ein Überbrückungsschalter (23) angeordnet ist, welcher insbesondere im aktiven Betriebszustand geschlossen ist.

11. Biegewerkzeug nach einem der Ansprüche 1 bis 10, **dadurch gekennzeichnet, dass** die Kommunikationsschnittstelle (9) drahtlos und zur Übertragung von elektrischer Energie und Kommunikationsdaten ausgebildet ist.

12. Biegewerkzeug nach einem der Ansprüche 1 bis 11, **dadurch gekennzeichnet, dass** die Kommunikationsschnittstelle (9) drahtlos ausgebildet ist.

13. Biegewerkzeug nach einem der Ansprüche 1 bis 12, **dadurch gekennzeichnet, dass** die Kommunikationsschnittstelle (9) als kontaktbasierter Mehrfachkontakt ausgebildet ist.

14. Betriebswechselverfahren eines Biegewerkzeugs, welches Biegewerkzeug (1) nach einem der Ansprüche 1 bis 13 ausgebildet ist, und wobei
das Biegewerkzeug (1) mit dem Befestigungsfortsatz (5) in einer Werkzeugaufnahme derart eingelegt wurde, dass die Kommunikationsschnittstelle (9) am Befestigungsfortsatz (5) einer Kommunikationsgegenstelle der Werkzeugaufnahme gegenüberliegend angeordnet ist, und dass
das Werkzeug-Identifikationsmerkmal mit der Kommunikationsschnittstelle (9) verbunden ist, was dem passiven Betriebszustand des Biegewerkzeugs (1) entspricht,
umfassend die Schritte:
• Überwachen des Spannungsversorgungskontakts (14) durch das Überwachungsmodul (20) des Spannungsversorgungsmoduls (15);
• Erkennen einer elektrischen Spannung am Spannungsversorgungskontakt (14) und generieren eines Umschaltsignals, welches aufgrund der Verbindung des Überwachungsmoduls (20) mit dem Umschalter (16), auch an diesem anliegt;
• Trennen der Verbindung zwischen dem Werkzeug-Identifikationskennzeichen (11) und der Kommunikationsschnittstelle (9) durch den Umschalter (16);
• Herstellen einer Verbindung zwischen der Elektronikeinheit (12) und der Kommunikationsschnittstelle (9) durch Anwenden des Umschaltsignals und damit Umsteuern des Umschalters (16) in die zweite Schaltstellung und somit Herstellen des aktiven Betriebszustands des Biegewerkzeugs (1);
• Aufrechterhalten der Verbindung zwischen der Elektronikeinheit (12) und der Kommunikationsschnittstelle (9) bis zur Erkennung einer fehlenden elektrischen Spannung am Spannungsversorgungskontakt (14) und dann Beenden des aktiven Betriebszustands und Herstellen des passiven Betriebszustands durch den Umschalter (16).

15. Betriebswechselverfahren nach Anspruch 14, **dadurch gekennzeichnet, dass** vor Herstellung des aktiven Betriebszustands, durch Anwenden des Umschaltsignals, der Überbrückungsschalter (23) geschlossen wird.

## Claims

1. A bending tool (1), in particular an upper tool or a bending punch, comprising a tool body (2) having an upper (3) and an opposite lower end region (4), wherein an attachment extension (5) is formed in the upper end region (3), and a working tip (6) is formed in the lower end region (4),
wherein the attachment extension (5) is designed for holding the bending tool (1) in a tool holder, and has a clamping section (7), and
wherein a tool identification marker (11) is disposed in the tool body (2), and wherein a communication interface (9) is disposed in the attachment extension (5), in particular outside of the clamping section (7), on at least one side surface (8) and not projecting beyond it, said interface being connected to the tool identification marker (11) via a connection line (10),
**characterized in that**
• sensor evaluation electronics (12) are disposed in the tool body (2), and
• that a voltage supply contact (14) that is electrically insulated relative to the tool body (2) is disposed on the attachment extension (5), which voltage supply contact (14) is connected to a voltage supply module (15) of the electronics unit (12), and
• that a change-over switch (16) having two inputs (17) and one output (18) is disposed in the connection line (10), wherein the output (18) is connected to the communication interface (9), and one of the inputs (17) is connected to the tool identification marker (11), and the other input (17) is connected to the electronics unit (12), and
• that in a first switching position, in particular in a rest position of the change-over switch (16), the tool identification marker (11) is connected to the communication interface (9) via the change-over switch (16), and
that in a second switching position of the change-over switch (16), the electronics unit (12) is connected to the communication interface (9) via the change-over switch (16), wherein the first switching position establishes a passive operational mode of the bending tool (1), and the second switching position establishes an active operational mode of the bending tool (1).

2. The bending tool according to claim 1, **characterized in that** the change-over switch (16) is configured as an electronic switch, in particular as a semiconductor switch.

3. The bending tool according to claim 1 or 2, **characterized in that** the change-over switch (16) is configured to be low in capacitance.

4. The bending tool according to one of claims 1 to 3, **characterized in that** a control connector (19) of the change-over switch (16) is connected to a monitoring module (20) of the voltage supply module (15), said monitoring module (20) being configured for the purpose of controlling the change-over switch (16) for changing between the two switching positions.

5. The bending tool according to one of claims 1 to 4, **characterized in that** the communication interface (9) is disposed on two opposite side surfaces of the attachment extension (5).

6. The bending tool according to one of claims 1 to 5, **characterized in that** an actuator element (21) is disposed in the clamping section (7), which actuator element (21) is motion-connected to the voltage supply contact (14), and is configured so as to move this voltage supply contact (14) between a position in which it does not project beyond the side surface (8) and a position in which it projects beyond the side surface (8).

7. The bending tool according to one of claims 1 to 6, **characterized in that** the electronics unit (12) is disposed in a recess of the tool body (2).

8. The bending tool according to one of claims 1 to 7, **characterized in that** the electronics unit (12) is connected to a bending characteristic data sensor (13), and which bending characteristic data sensor (13) is preferably disposed in the lower end region (4).

9. The bending tool according to claim 8, **characterized in that** the bending characteristic data sensor (13) is configured as a tactile disk sensor.

10. The bending tool according to one of claims 1 to 9, **characterized in that** a bridging switch (23) is disposed in the tool identification marker (11), which switch is closed, in particular, in the active operational state.

11. The bending tool according to one of claims 1 to 10, **characterized in that** the communication interface (9) is configured in wireless manner and for transmission of electrical energy and communication data.

12. The bending tool according to one of claims 1 to 11, **characterized in that** the communication interface (9) is configured in wireless manner.

13. The bending tool according to one of claims 1 to 12, **characterized in that** the communication interface (9) is configured as a contact-based multiple contact.

14. A method for operational change-over of a bending tool, which bending tool (1) is configured according to one of claims 1 to 13, and wherein
the bending tool (1) was inserted into a tool holder with the attachment extension (5), in such a manner that the communication interface (9) is disposed on the attachment extension (5) so as to lie opposite a communication counter-location of the tool holder, and
that the tool identification marker is connected with the communication interface (9), and this corresponds to the passive operational state of the bending tool (1), comprising the steps:
• monitoring the voltage supply contact (14) by means of the monitoring module (20) of the voltage supply module (15);
• recognizing an electrical voltage at the voltage supply contact (14) and generating a change-over signal, which is also applied to the change-over switch (16) due to the connection of the monitoring module (20) with this switch;
• separating the connection between the tool identification marker (11) and the communication interface (9) by means of the change-over switch (16);
• producing a connection between the electronics unit (12) and the communication interface (9) by using the change-over signal and thereby changing the change-over switch (16) to the second switching position and thereby establishing the active operational state of the bending tool (1);
• maintaining the connection between the electronics unit (12) and the communication interface (9) until the absence of an electrical voltage at the voltage supply contact (14) is recognized, and then terminating the active operational state and establishing the passive operational state, by means of the change-over switch (16).

15. The method for operational change-over according to claim 14, **characterized in that** the bridging switch (23) is closed before establishment of the active operational state, by means of use of the change-over signal.

## Revendications

1. Outil de pliage (1), plus particulièrement outil supérieur ou matrice de pliage, comprenant un corps d'outil (2) avec une partie d'extrémité supérieure (3) et une partie d'extrémité inférieure (4) opposée, dans lequel, dans la partie d'extrémité supérieure (3), un prolongement de fixation (5) et, dans la partie d'extrémité inférieure (4), une pointe de travail (6) est réalisée,
dans lequel le prolongement de fixation (5) est conçue pour le logement de l'outil de pliage (1) dans un logement d'outil et comprend une portion de serrage (7) et
dans lequel, dans le corps d'outil (2) est disposé un repère d'identification d'outil (11) et
dans lequel, dans le prolongement de fixation (5), plus particulièrement à l'extérieur de la portion de serrage (7), au niveau d'au moins une surface latérale (8) et ne dépassant pas celle-ci, est disposée une interface de communication (9) qui est reliée par l'intermédiaire d'une conduite de liaison (10) avec le repère d'identification d'outil (11),
**caractérisé en ce que**
• dans le corps d'outil (2) est disposée une électronique d'analyse de capteur (12) et
• sur le prolongement de fixation (5) est disposé un contact d'alimentation en tension (14) isolé électriquement par rapport au corps d'outil (2), qui est relié avec un module d'alimentation en tension (15) de l'unité électronique (12) et
• dans la conduite de liaison (10) est disposé un commutateur (16) avec deux entrées (17) et une sortie (18), dans lequel la sortie (18) est reliée avec l'interface de communication (9) et une des entrées (17) est reliée avec le repère d'identification d'outil (11) et l'autre entrée (17) est reliée avec l'unité électronique (12) et
• dans une première position de commutation, plus particulièrement une position de repos du commutateur (16), le repère d'identification d'outil (11) est relié par l'intermédiaire du commutateur (16) avec l'interface de communication (9) et
dans une deuxième position de commutation du commutateur (16), l'unité électronique (12) est reliée par l'intermédiaire du commutateur (16) avec l'interface de communication (9),
dans lequel la première position de commutation définit un mode de fonctionnement passif de l'outil de pliage (1) et la deuxième position de commutation définit un mode de fonctionnement actif de l'outil de pliage (1).

2. Outil de pliage selon la revendication 1, **caractérisé en ce que** le commutateur (16) est conçu comme un commutateur électronique, plus particulièrement comme un commutateur semi-conducteur.

3. Outil de pliage selon la revendication 1 ou 2, **caractérisé en ce que** le commutateur (16) est conçu de manière à présenter une faible capacité.

4. Outil de pliage selon l'une des revendications 1 à 3, **caractérisé en ce qu'**un raccord de commande (19) du commutateur (16) est relié avec un module de surveillance (20) du module d'alimentation en tension (15), ce module de surveillance (20) étant conçu pour commuter le commutateur (16) entre les deux positions de commutation.

5. Outil de pliage selon l'une des revendications 1 à 4, **caractérisé en ce que** l'interface de communication (9) est disposé sur deux surfaces latérales opposées du prolongement de fixation (5).

6. Outil de pliage selon l'une des revendications 1 à 5, **caractérisé en ce que**, dans la portion de serrage (7), est disposé un élément d'actionnement (21) qui est relié en mouvement avec le contact d'alimentation en tension (14) et qui est conçu pour le déplacement de ce contact d'alimentation en tension (14) entre une position ne dépassant pas de la surface latérale (8) et une position dépassant de la surface latérale (8).

7. Outil de pliage selon l'une des revendications 1 à 6, **caractérisé en ce que** l'unité électronique (12) est disposée dans un évidement du corps d'outil (2).

8. Outil de pliage selon l'une des revendications 1 à 7, **caractérisé en ce que** l'unité électronique (12) est reliée avec un capteur de données caractéristiques de pliage (13) et ce capteur de données caractéristiques de pliage (13) est de préférence disposé dans la partie d'extrémité inférieure (4).

9. Outil de pliage selon la revendication 8, **caractérisé en ce que** le capteur de données caractéristiques de pliage (13) est conçu comme un capteur à galets palpeurs.

10. Outil de pliage selon l'une des revendications 1 à 9, **caractérisé en ce que**, dans le repère d'identification d'outil (11) est disposé un commutateur de pontage (23) qui est plus particulièrement fermé dans l'état de fonctionnement actif.

11. Outil de pliage selon l'une des revendications 1 à 10, **caractérisé en ce que** l'interface de communication (9) est conçue sans fil et est conçue pour la transmission d'énergie électrique et de données de communication.

12. Outil de pliage selon l'une des revendications 1 à 11, **caractérisé en ce que** l'interface de communication (9) est conçue sans fil.

13. Outil de pliage selon l'une des revendications 1 à 12, **caractérisé en ce que** l'interface de communication (9) est conçue comme un contact multiple basé sur le contact.

14. Procédé de changement de fonctionnement d'un outil de pliage, cet outil de pliage (1) étant conçu selon l'une des revendications 1 à 13 et dans lequel l'outil de pliage (1) a été inséré, avec le prolongement de fixation (5), dans un logement d'outil de façon à ce que l'interface de communication (9) soit disposée sur le prolongement de fixation (5) de manière opposée à un poste distant de communication du logement d'outil et en ce que
la caractéristique d'identification d'outil est reliée avec l'interface de communication (9), ce qui correspond au mode de fonctionnement passif de l'outil de pliage (1), comprenant les étapes suivantes :
• surveillance du contact d'alimentation en tension (14) par le module de surveillance (20) du module d'alimentation en tension (15) ;
• détection d'une tension électrique au niveau du contact d'alimentation en tension (14) et génération d'un signal de commutation qui, du fait de la liaison du module de surveillance (20) avec le commutateur (16), est également appliqué à celui-ci ;
• coupure de la liaison entre le repère d'identification d'outil (11) et l'interface de communication (9) par le commutateur (16) ;
• établissement d'une liaison entre l'unité électronique (12) et l'interface de communication (9) par l'application du signal de commutation et donc le passage du commutateur (16) dans la deuxième position de commutation et donc établissement du mode de fonctionnement actif de l'outil de pliage (1) ;
• maintien de la liaison entre l'unité électronique (12) et l'interface de communication (9) jusqu'à la détection d'une absence de tension électrique au niveau du contact d'alimentation en tension (14) puis terminaison du mode de fonctionnement actif et établissement du mode de fonctionnement passif par le commutateur (16).

15. Procédé de changement de fonctionnement selon la revendication 14, **caractérisé en ce que**, avant l'établissement du mode de fonctionnement actif, par l'application du signal de commutation, le commutateur de pontage (23) est fermé.
